# FASCICULE DE BREVET EUROPEEN

(11) **EP 0 543 981 B1**
(45) Date de publication et mention de la délivrance du brevet: **21.08.1996**
(21) Numéro de dépôt: 92913140.7
(22) Date de dépôt: 12.06.1992
(51) Int. Cl.: H02B 1/056

(54) **DISPOSITIF D'INTERFACE POUR UNITE DE TRAITEMENT NOTAMMENT AUTOMATE**
SCHNITTSTELLENEINRICHTUNG FÜR EINE VERARBEITUNGSEINHEIT, INSBESONDERE EINE PROGRAMMIERBARE STEUERUNG
INTERFACE DEVICE FOR PROCESSING UNIT, PARTICULARLY A LOGIC CONTROLLER

(30) Priorité: 14.06.1991 FR 9107315
(43) Date de publication de la demande: 02.06.1993
(73) Titulaire: SCHNEIDER ELECTRIC SA, F-92100 Boulogne-Billancourt (FR)
(72) Inventeur: NOURRY, Daniel, F-21000 Dijon (FR); THIERRY, Jean-Pierre, F-21560 Couternon (FR)
(74) Mandataire: Carias, Alain
(86) Numéro de dépôt international: FR9200535
(87) Numéro de publication internationale: WO9222947

(56) Documents cités:
- EP-A- 0 229 590
- EP-A- 0 325 371
- EP-A- 0 364 618
- FR-A- 2 223 937
- US-A- 3 258 652
- US-A- 3 611 048
- US-A- 4 004 197
- US-A- 4 152 750
- US-A- 4 909 551

## Description

La présente invention concerne un dispositif d'interface destiné à être interposé électriquement entre une unité de traitement telle qu'un automate programmable et l'installation commandée par ce dernier.

Un automate programmable reçoit sur ses entrées des informations en provenance de détecteurs, traite ces informations et émet sur ses sorties des ordres à destination d'actionneurs. Les dispositifs d'interface sont placés entre les détecteurs et les entrées de l'automate et entre les sorties de l'automate et les actionneurs. Il s'agit par exemple de relais pour réaliser une adaptation de tension entre les détecteurs et les entrées de l'automate ou entre les sorties de l'automate et les actionneurs. Il peut encore s'agir de dispositifs de découplage galvanique tels que des optocoupleurs, des dispositifs indicateurs d'état, par exemple à diode électro-luminescente, ou encore de simples dispositifs "transparents", c'est-à-dire assurant une liaison directe entre le détecteur et l'entrée de l'automate ou respectivement entre la sortie de l'automate et l'actionneur.

On connaît actuellement deux types de dispositifs d'interface pour automate.

Le premier type est constitué de dispositifs élémentaires spécifiques de la fonction d'interface qu'ils assurent pour une entrée ou une sortie de l'automate. Ces dispositifs élémentaires sont montés côte à côte, par exemple sur un rail de fixation, et sont câblés de manière artisanale en fonction de l'équipement à réaliser cas par cas. On conçoit aisément que le montage est relativement long à réaliser et entraîne des risques d'erreurs de câblage difficiles à localiser.

On connait par ailleurs les dispositifs d'interface précâblés ( document US-A-4,909,551 ), dans lesquels des modules d'interface tous identiques sont reliés par une embase renfermant un circuit imprimé dont part un câble de raccordement à l'automate. Le montage est donc extrêmement rapide. Par contre, la souplesse de conception de l'équipement à réaliser est très réduite : comme les modules sont tous identiques, il est impossible de réaliser un dispositif d'interface panachant des fonctions d'interface différentes. Bien plus, il n'est même pas possible de disposer rationnellement les modules par rapport à l'installation commandée, par exemple en regroupant côte à côte les modules assurant l'interface avec une partie déterminée de l'installation, car chaque module, certes identique aux autres, est cependant particularisé par sa position sur le circuit imprimé. De plus, bien que le dispositif d'interface connu existe en différentes tailles, il est généralement impossible d'acquérir un dispositif ayant juste la taille nécessaire pour l'équipement à réaliser : on doit alors acquérir un dispositif de taille surabondante dont une partie restera inutilisée.

Le but de l'invention est de remédier à ces inconvénients et en particulier de proposer un dispositif d'interface dont le montage soit facile et qui soit néanmoins peu onéreux et facile à adapter à des besoins variés.

L'invention concerne un dispositif d'interface présentant les caractéristiques énoncées dans la revendication 1.

Ainsi, on peut monter sur l'embase, côte à côte, de manière jointive ou non, des modules de fonctions et de largeurs différentes. L'embase est très économique à réaliser et elle a le double avantage de ne pas figer dès le départ la conception et l'organisation de l'équipement à réaliser tout en supprimant quand même la nécessité de réaliser à l'extérieur le câblage des communs. On peut ainsi utiliser des modules ayant des fonctions très variées et utiliser pour chaque application un nombre de modules limité offrant une largeur totale réduite. On peut en outre organiser ces modules par groupes correspondant aux parties de l'installation à commander. Le "croisement des fils" s'effectue non plus entre le dispositif d'interface et l'installation mais entre les modules et l'automate, ce qui est beaucoup moins gênant.

D'autres particularités et avantages de l'invention ressortiront encore de la description ci-après, relative à des exemples non limitatifs.

Aux dessins annexés :
- la figure 1 est un schéma électrique partiel d'un exemple d'entrées actives d'un automate programmable ;
- la figure 2 est un schéma électrique partiel d'un exemple d'entrées passives d'un automate programmable ;
- la figure 3 est un schéma électrique partiel d'un exemple de sorties actives d'un automate programmable ;
- la figure 4 est un schéma électrique partiel d'un exemple de sorties passives d'un automate programmable ;
- la figure 5 est une vue en perspective d'un premier mode de réalisation du dispositif d'interface selon l'invention ;
- la figure 6 est une vue de face du dispositif de la figure 5 avec arrachement partiel des modules ;
- la figure 7 est une vue en élévation latérale, avec coupe partielle, de l'embase du dispositif des figures 5 et 6, montrant plus particulièrement le bloc d'alimentation ;
- la figure 8 est une vue de face d'un module ;
- la figure 9 est une vue en coupe transversale partielle du dispositif, avec un module représenté écarté de l'embase à la moitié inférieure de la figure ;
- la figure 10 est une vue en perspective avec arrachement d'un deuxième mode de réalisation du dispositif selon l'invention ;
- la figure 11 est une vue en coupe transversale partielle du dispositif de la figure 10 ;
- la figure 12 est une vue de face d'un module du dispositif des figures 10 et 11 ;
- la figure 13 est une vue en perspective d'un troisième mode de réalisation du dispositif d'interface ;
- la figure 14 est une vue en élévation et coupe schématique du dispositif de la figure 13 ; et
- la figure 15 est une vue en perspective sur laquelle on a regroupé deux autres modes de réalisation du dispositif selon l'invention ;
- la figure 16 est une vue analogue à la figure 1, mais relative à un autre mode de réalisation de l'invention;
- la figure 17 est une vue en coupe longitudinale d'un module de commun de la figure 16 ;
- la figure 18 est une vue en perspective d'un dispositif selon la figure 16 ;
- la figure 19 est une vue de face du dispositif de la figure 18 ;
- la figure 20 est une vue schématique en élévation et coupe partielle du dispositif des figures 18 et 19.

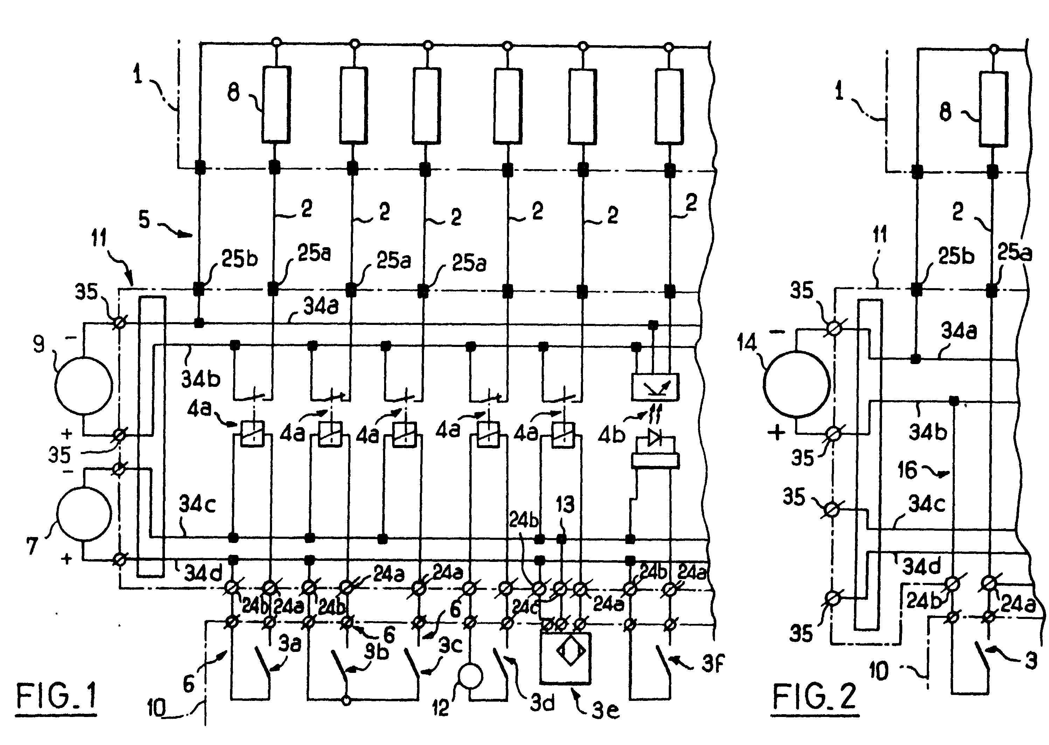

Dans l'exemple représenté à la figure 1, un automate programmable 1 qui n'est représenté que partiellement et très schématiquement reçoit sur ses entrées de signal 2 des signaux qui sont fonction de l'état de détecteurs 3a-3f placés en général sur l'installation 10 que l'automate 1 doit piloter.

L'état des détecteurs 3a-3f est transmis aux entrées de signal 2 de l'automate 1 par l'intermédiaire du dispositif d'interface 11 selon l'invention qui comprend, entre des bornes de signal d'installation 24a et des bornes de signal de traitement 25a, des relais qui dans l'exemple sont des relais électromécaniques 4a ou un optocoupleur 4b. Le dispositif d'interface 11 comprend quatre conducteurs de commun 34a à 34d reliés chacun à une borne d'alimentation respective 35 du dispositif d'interface. A l'extérieur du dispositif d'interface 11, une source d'alimentation "installation" 7 et une source d'alimentation "traitement" 9 sont montées chacune entre deux respectives des bornes d'alimentation 35. Il y a pour chaque entrée de signal 2 de l'automate 1 un circuit de traitement 5 et un circuit de détection 6 situés chacun en partie dans le dispositif d'interface 11 et en partie hors de celui-ci. Dans le circuit de détection 6 le détecteur 3a- 3f est en série avec l'organe de commande du relais 4a ou 4b et avec la source d'alimentation "installation" 7 ou une source extérieure 12. Dans le circuit d'entrée 5, un moyen de traitement 8 de l'automate programmable 1, associé à l'entrée 2 considérée est en série avec l'organe commandé du relais 4a ou 4b et avec la source d'alimentation "traitement" 9. Chaque circuit d'entrée 5 ou de détection 6, pour son raccordement à la source 7 ou 9, est en pratique raccordé aux conducteurs 34a à 34d correspondants dans le dispositif d'interface 11.

On voit encore à la figure 1 que les circuits de détection 6 et d'entrée 5 ne sont pas tous raccordés de la même manière aux sources 7 et 9. Les détecteurs 3a, 3b, 3e et 3f sont montés entre leur borne de signal "installation" 24a et une borne de commun "installation" 24b respective, reliée directement dans le dispositif d'interface 11 à l'un des conducteurs de commun 34d. Le détecteur 3e est en outre associé à un troisième raccordement 13 qui lui fournit une tension de référence par l'intermédiaire d'une deuxième borne de commun 24c. Le détecteur 3c est monté entre une borne de signal 24a du dispositif d'interface 11 et la borne à potentiel fixe du détecteur 3b. Le détecteur 3d coopère avec sa propre source 12 et n'est pas du tout raccordé à la source 7.

Dans l'exemple représenté, les circuits d'entrée 5 sont tous interconnectés entre eux dans l'automate 1 de sorte qu'il suffit que l'un d'entre eux (celui qui est à gauche à la figure 1) soit relié à une borne de commun "traitement" 25b du dispositif d'interface 11. La borne 25b est reliée dans le dispositif d'interface 11 à l'un 34 des conducteurs de commun 34a et 34b. Les autres circuits ne sont reliés qu'à une borne de signal "traitement" 25a respective du dispositif d'interface 11.

La figure 2 montre un exemple d'entrée passive. Chaque détecteur 3 est monté en série avec un moyen de traitement 8 de l'automate et avec une source de tension 14 qui a en général les mêmes caractéristiques que la source "traitement" 9 de la figure 1. Il y a donc un circuit d'entrée et de détection 16 pour chaque entrée de signal 2, au lieu d'un circuit de détection et d'un circuit d'entrée séparés dans l'exemple de la figure 1. Les conducteurs 34c et 34d sont prévus, mais ils sont inutilisés, et aucune source n'est montée entre les bornes 35 correspondantes.

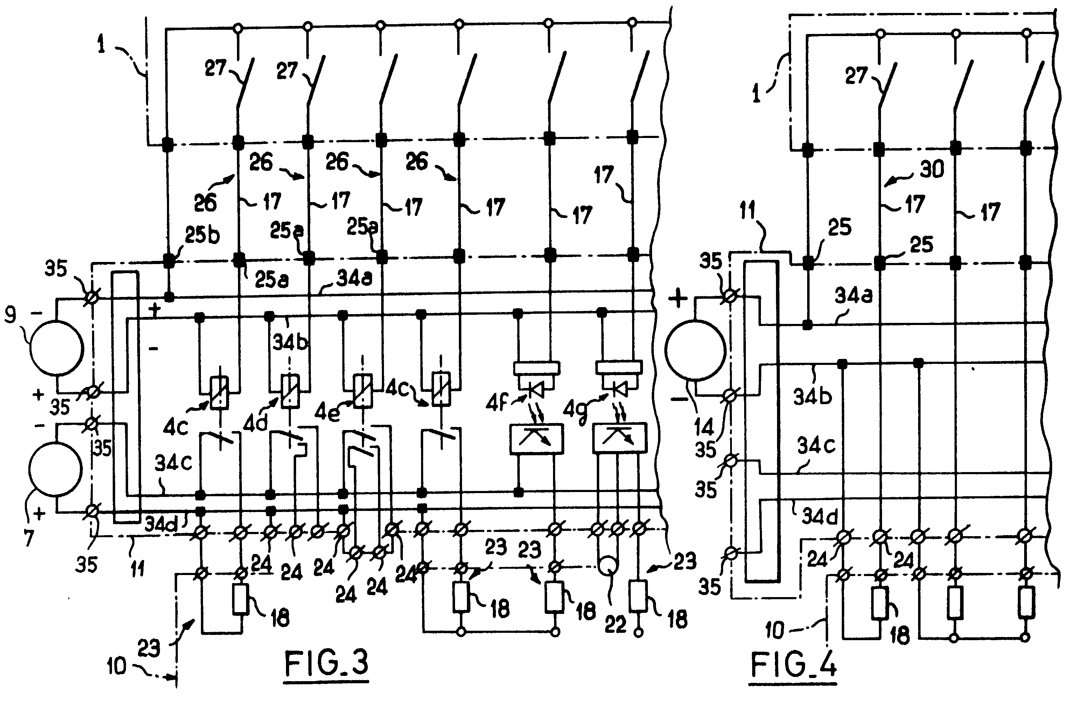

En fonction des informations collectées sur les entrées de signal 2 de la figure 1 ou 2, l'automate 1 fournit sur des sorties de signal 17 (figures 3 et 4) des commandes qui sont transmises à des actionneurs 18 de l'installation à piloter, par l'intermédiaire du dispositif d'interface 11 qui a ici une fonction globale d'interface de sortie et qui comprend pour chaque sortie de signal 17 un relais qui peut être un relais électromécanique 4c à un seul contact de travail, un relais électromécanique 4d à deux contacts de travail, un relais 4e à deux contacts actionnés en parallèle, un optocoupleur 4f alimenté par la source "installation" 7 et un optocoupleur 4g à alimentation extérieure par une source 22. On voit que les différents circuits d'actionnement correspondants 23, qui ne sont pas tous complètement représentés, nécessitent de une à quatre bornes d'installation 24, de signal ou de commun, pour chaque sortie de signal 17 de l'automate 1. Dans chaque circuit d'actionnement 23, la partie commandée de l'un des relais 4c à 4g est en série avec un actionneur 18, entre les conducteurs 34c et 34d ou entre les bornes de sources extérieures. Une telle source n'est pas illustrée mais serait nécessaire pour le contact inférieur du relais 4e, qui n'est pas relié aux conducteurs de commun 34a à 34d.

Les circuits de sortie 26 affectés à chaque sortie de signal 17 comprennent en série un interrupteur 27 à l'intérieur de l'automate 1 et un organe de commande de l'un des relais 4c à 4g. Les différents circuits de sortie 26 sont interconnectés dans l'automate 1 de sorte qu'il suffit que l'un d'entre eux (celui de gauche à la figure 3) soit relié non seulement à une borne de signal "traitement" 25a mais aussi à une borne de commun "traitement" 25b du dispositif d'interface 11, les autres n'étant reliés qu'à une borne de signal 25a.

La figure 4 montre un exemple de sorties passives c'est-à-dire comportant pour chaque sortie de signal 17 de l'automate 1 un seul circuit de sortie et d'actionnement 30, dans lequel l'interrupteur 27 de l'automate est en série avec l'actionneur 18 de l'installation et avec la source commune 14.

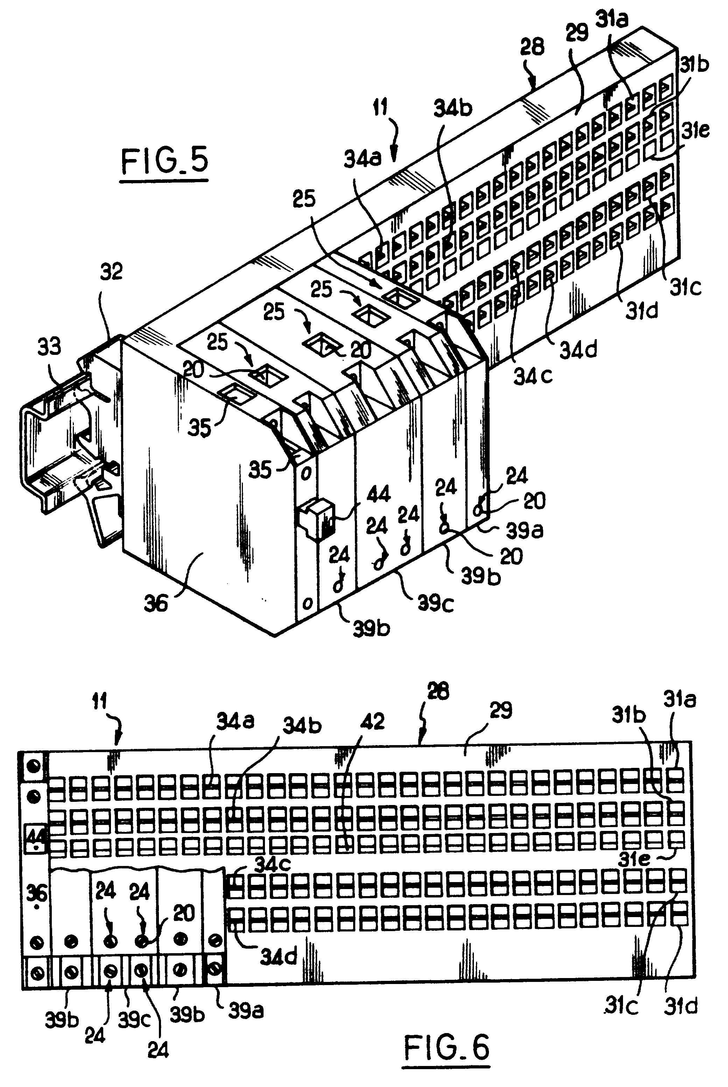

Comme le montre la figure 5, le dispositif d'interface 11 comprend une embase 28 présentant une paroi faciale 29 à travers laquelle sont ménagées cinq rangées de fenêtres 31a, 31b, 31c, 31d et 31e. Les fenêtres 31a à 31e sont également disposées en colonnes perpendiculaires aux rangées, chaque colonne comportant une fenêtre de chaque rangée.

Sur sa paroi opposée aux fenêtres 31a-31e, l'embase 28 porte des patins de type connu 32 pour la fixation du dispositif d'interface 11 sur un rail 33.

Sous chacune des rangées de fenêtres 31a à 31d, est disposé un fil de cuivre 34a à 34d respectif (figure 6) qui concrétise les conducteurs 34a à 34d des figures 1 à 4.

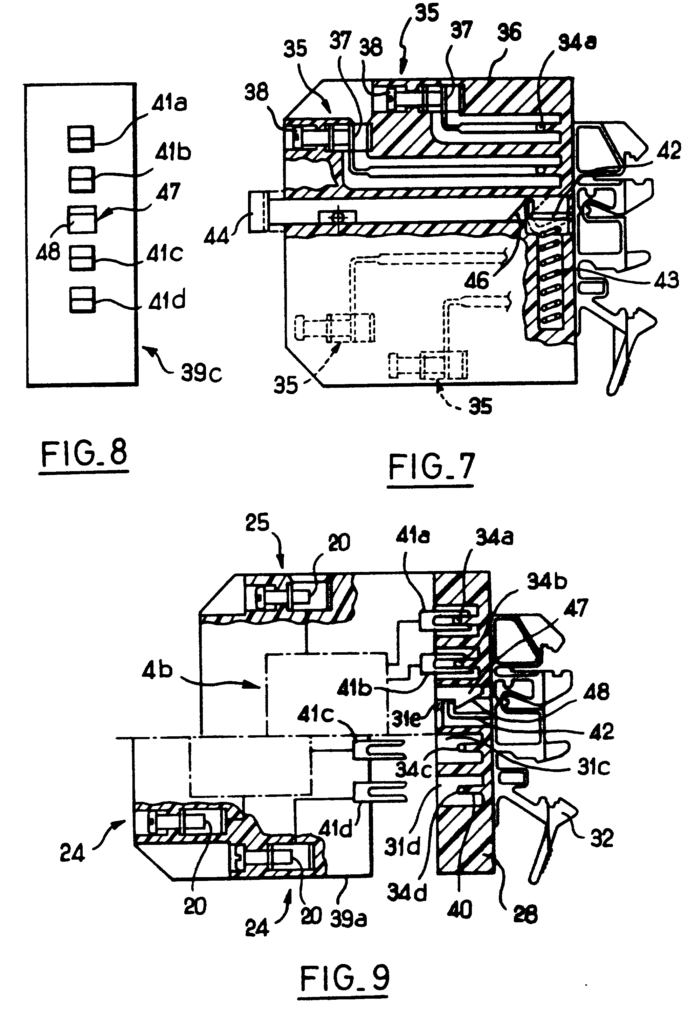

Comme représenté à la figure 9, chaque fil 34a à 34d est fixé au sommet d'une nervure longitudinale 40 de l'embase 28.

Comme le montre encore la figure 5, l'embase 28 porte à l'une de ses extrémités un module de raccordement d'alimentation 36 qui s'étend parallèlement aux colonnes de fenêtres 31a-31e et fait saillie par rapport à la paroi faciale 29. Dans le module ou bloc d'alimentation 36 (figure 7), les conducteurs 34a à 34d sont chacun coudés deux fois pour se terminer, à l'une des bornes d'alimentation 35 en une extrémité aplatie 37 formant cosse de serrage actionnée par une vis 38.

Le dispositif d'interface comprend en outre des modules d'interface 39a, 39b, 39c (figures 5, 6, 8, 9) qui se montent contre la paroi faciale 29 de l'embase et présentent, en direction de cette paroi, des pinces de contact 41a, 41b, 41c, 41d qui s'enfichent sur les conducteurs 34a-34d et coïncident respectivement avec les fenêtres 31a à 31d d'une même colonne de la paroi faciale 29.

Un tel module à quatre pinces de contact 41a à 41d peut par exemple réaliser l'interface entre le détecteur 3f de la figure 1 et l'entrée de signal 2 correspondante de l'automate.

Dans le cas représenté par le détecteur 3c à la figure 1, où il suffit d'une liaison avec la borne négative de la source "installation" 7 et d'une seule liaison avec la borne positive de la source "traitement" 9, le module ne comportera que deux pinces, par exemple 41b et 41c.

Dans le cas du détecteur 3e où il y a deux raccordements avec la borne négative de la source "installation" 7, la pince correspondante 41c pourra être reliée à un conducteur ramifié à l'intérieur du module correspondant.

Dans l'exemple représenté, les bornes de traitement 25 et d'installation 24 sont prévues sur les modules eux-mêmes. Chaque module comprend ainsi au moins trois serre-fils 20 pour réaliser au moins une borne de traitement 25 pour le raccordement avec l'automate et deux bornes d'installation 24 pour le raccordement avec l'installation.

A l'intérieur du module, ces bornes 24 et 25 sont reliées avec le relais 4b et respectivement avec la pince de contact 41d pour permettre la réalisation du schéma électrique associé au détecteur 3f à la figure 1, mais bien entendu d'autres raccordements sont possibles selon la fonction spécifique de chaque module.

Ainsi, pour réaliser un dispositif d'interface tel que l'un ou l'autre de celui des figures 1 ou 3, il suffit de sélectionner les modules correspondant au type de relais 4a à 4g que l'on désire associer à chaque entrée de signal 2 ou sortie de signal 17 de l'automate, de monter les différents modules côte à côte dans n'importe quel ordre sur l'embase 28, raccorder chaque module avec le détecteur et l'entrée de signal ou respectivement la sortie de signal et l'actionneur qui doivent lui correspondre, et raccorder les bornes 35 du bloc d'alimentation 36 avec les sources 7 et 9. Pour réaliser un dispositif d'interface passif tel que celui des figures 2 et 4, on utilise des modules très simples qui ne renferment que des raccordements entre leurs bornes 24 et 25 et leur(s) pince(s) 41a et/ou 41b.

Certains modules, notamment ceux associés à des entrées ou des sorties passives, peuvent être très peu encombrants en largeur et ne recouvrir qu'une seule colonne de fenêtres 31a à 31e. C'est le cas du module 39a à la figure 5 et 6. D'autres modules contiennent des relais assez volumineux. On leur donne selon l'invention une largeur correspondant à un nombre entier de fois le pas de répétition des colonnes de fenêtres 31a à 31e. Ainsi, aux figures 5 et 6, les modules 39b ont une largeur correspondant à deux pas de répétition des colonnes de fenêtres et le module 39c a une largeur correspondant à trois pas de répétition des modules.

De plus, comme on l'a vu à propos du détecteur 3e ou de la sortie des relais 4d, 4e et 4g, certains modules ont trois ou même quatre bornes extérieurs d'installation 24. C'est pourquoi on a représenté à la figure 6 le module 39c muni de quatre bornes extérieures d'installation 24.

En général, les modules plus larges 39b et 39c (figure 8), bien que recouvrant deux ou respectivement trois colonnes de fenêtres, ne comportent qu'au maximum quatre pinces 41a à 41d ne coopérant qu'avec une seule colonne de fenêtres. La liaison à partir de l'une de ces pinces peut être ramifiée à l'intérieur du module si cela est nécessaire, pour réaliser par exemple, pour le détecteur 3e de la figure 1, les deux liaisons nécessaires avec la borne négative de la source 7. Mais pour éviter de telles ramifications, il est également possible qu'un module comporte deux pinces pour passer à travers deux fenêtres de la même rangée.

Sous la rangée de fenêtres 31e, disposée de manière centrale, est monté un verrou 42 en forme de cornière (figure 7) commun à toutes les colonnes de fenêtres. Le verrou 42 est monté pour basculer à partir d'une position de verrouillage, représentée en traits pleins, dans laquelle il ferme partiellement les fenêtres 31e (voir aussi figure 9), jusqu'à une position de déverrouillage représentée en pointillés, à l'encontre d'un ressort de rappel 43 monté dans le bloc d'alimentation 36. Ce dernier renferme également un poussoir de déverrouillage 44 terminé par une rampe 46 qui, lorsqu'on enfonce manuellement le poussoir 44, agit sur le bord libre du verrou 42 pour faire passer le verrou 42 dans la position de déverrouillage à l'encontre du rappel du ressort 43.

Chaque module porte une conformation de verrouillage constituée par un bec d'encliquetage 47 (figure 9). Normalement, le verrou 42 est dans la position de verrouillage représentée à la figure 9. Lorsqu'on monte un module sur l'embase 28, la pente frontale 48 du bec 47 repousse passagèrement le verrou 42 en position de déverrouillage jusqu'à ce que, lorsque le module est en place, le verrou 42 soit ramené en position de verrouillage par le ressort 43 et coopère avec le bec 47 pour maintenir et verrouiller le module en place sur l'embase 28. Pour enlever un module, on presse le poussoir 44 du bloc d'alimentation 36 pour faire passer le verrou 42 en position de déverrouillage et on tire vers soi le module qu'on désire démonter. Lorsque le verrou 42 est en position de déverrouillage, tous les modules sont déverrouillés mais seul celui qu'on tire à soi est démonté, les autres restant en place par frottement des pinces 41a à 41d sur les conducteurs 34a à 34d et du bec 47 dans la fenêtre 31e correspondante.

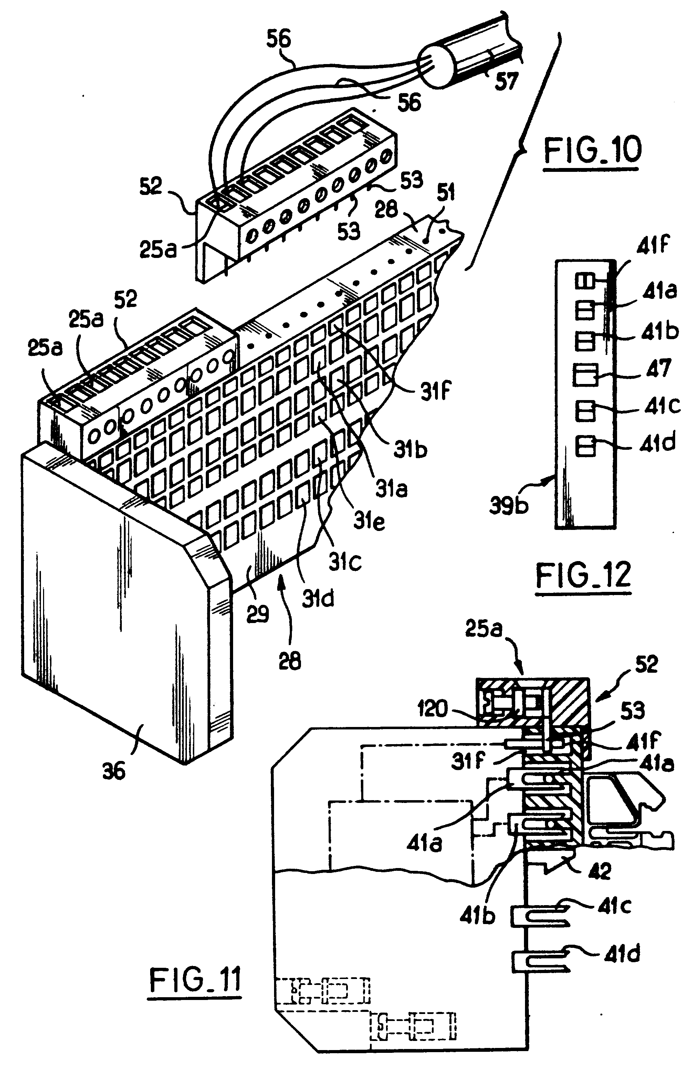

Dans l'exemple représenté aux figures 10 à 12, chaque colonne de fenêtres comprend en outre une fenêtre de signal 31f qui est voisine de l'un des bords longitudinaux de l'embase 28 et qui communique par l'intérieur de l'embase 28 avec un puits de branchement respectif 51 prévu latéralement sur l'embase 28 le long du même bord.

Les bornes de signal de traitement 25a ne sont plus sur les modules, mais sont des serre-fils 120 appartenant à des borniers 52, de chacun neuf serre-fils 120 dans l'exemple, reliées chacun à une fiche de contact respective 53 du bornier. Comme le montre la figure 11, les fiches 53, capables de pénétrer simultanément dans neuf puits 51 successifs, font alors saillie chacune dans l'une des fenêtres 31f selon la direction des colonnes de fenêtres, donc perpendiculairement aux conducteurs de commun 34a à 34d.

Chaque module comprend, outre certaines au moins des pinces 41a à 41d comme exposé précédemment, une pince supplémentaire 41f qui est orientée à 90° par rapport aux pinces 41a à 41d (voir aussi figure 12).

La pince 41f vient serrer la fiche 53 dans la fenêtre 31f lorsque le module est en place sur l'embase. Chaque serre-fil 120 (figure 11) est destiné à recevoir par exemple l'un des fils individuels 56 (figure 10) d'un câble 57 relié à l'automate programmable non représenté sur ces figures.

On pourrait prévoir que le module associé à la borne de commun "traitement" 25b (figures 1, 3) comporte deux pinces 41f, qui seraient reliéres à deux serre-fils 120 du bornier 52, dont l'un constituerait alors la borne de commun 25b de la figure 1.

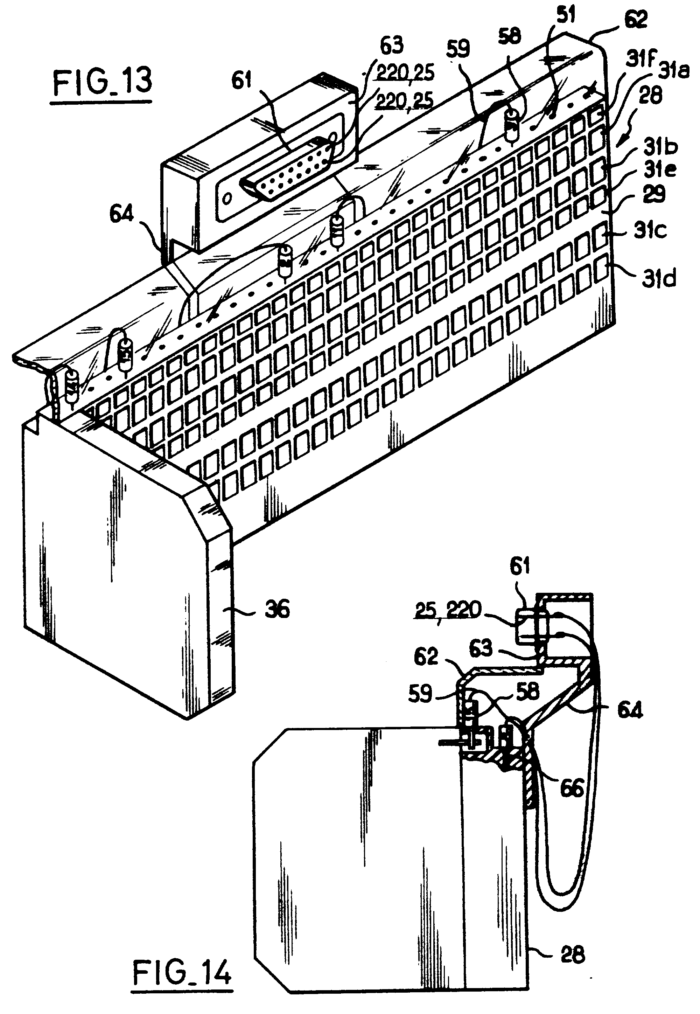

Dans l'exemple représenté à la figure 13, l'embase 28 est identique à celle de la figure 10 mais les puits 51 reçoivent non pas des borniers 52, lesquels sont supprimés, mais des fiches de connexion individuelles 58 reliées chacune par un fil souple 59 à l'une respective des bornes de traitement 25 qui sont ici constituées par les broches de contact 220 d'un connecteur multibroche 61 destiné à recevoir un connecteur complémentaire non représenté monté a l'extrémité d'un câble de liaison avec l'automate. L'une des broches 220 peut constituer la borne de commun 25b des figures 1 et 3, les autres constituant les bornes de signal 25a. Un capot 62, rapporté sur l'embase 28 pour surplomber les puits 51 dans le prolongement de la paroi faciale 29 munie des fenêtres 31a à 31f, protège les fiches de connexion 58, notamment pour éviter leur débranchement involontaire. Le capot 62 est de préférence transparent et permet de reconnaître sur chaque fiche individuelle 58 un numéro d'identification porté sur celle-ci et indiquant à quelle broche 220 du connecteur le fil 59 est raccordé.

La figure 14 montre schématiquement comment chaque fil individuel 59 est soudé à l'extrémité arrière des broches 220 du connecteur 61, lequel est monté à travers une paroi 63 d'un support 64 fixé à la paroi arrière de l'embase 28. L'embase 28 comporte en outre dans sa matière plastique des trous 66 pour recevoir les fiches individuelles non utilisées lorsque le connecteur 61 comporte davantage de broches 220 que cela est nécessaire dans une application déterminée.

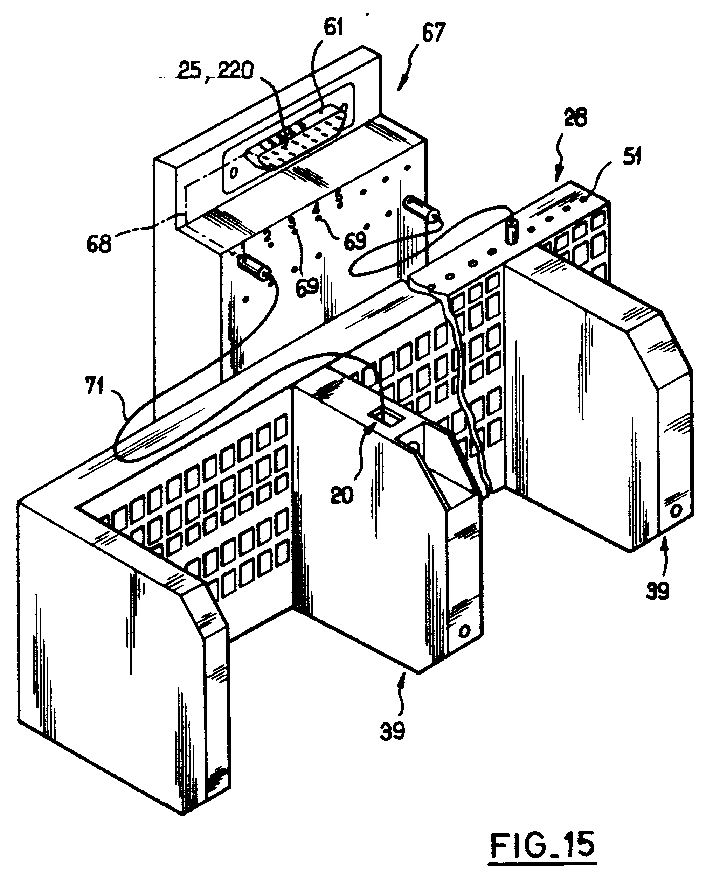

Dans l'exemple de la figure 15, le connecteur 61 est monté sur un boîtier de répartition 67 dans lequel, comme représenté schématiquement par un trait mixte 68, chaque borne extérieure de traitement 25 (broche 220) du connecteur 61 est reliée de manière interne avec un contact femelle 69 respectif prévu sur la face avant du boîtier 67. On peut ainsi par un fil souple 71 terminé à chaque extrémité par une fiche mâle, relier l'un des contacts femelles 69 du boîtier 67 avec un puits 51 de l'embase lorsque celle-ci en comporte (partie droite de la figure 15) ou bien avec un serre-fil 20 d'un module 39 si l'embase et les modules sont par exemple du type décrit en référence aux figures 1 à 9.

Les modes de réalisation des figures 10 à 15 permettent de rationaliser les liaisons entre le dispositif d'interface et l'automate, de confiner les fils de liaison à l'arrière du dispositif, et de faciliter les opérations de câblage.

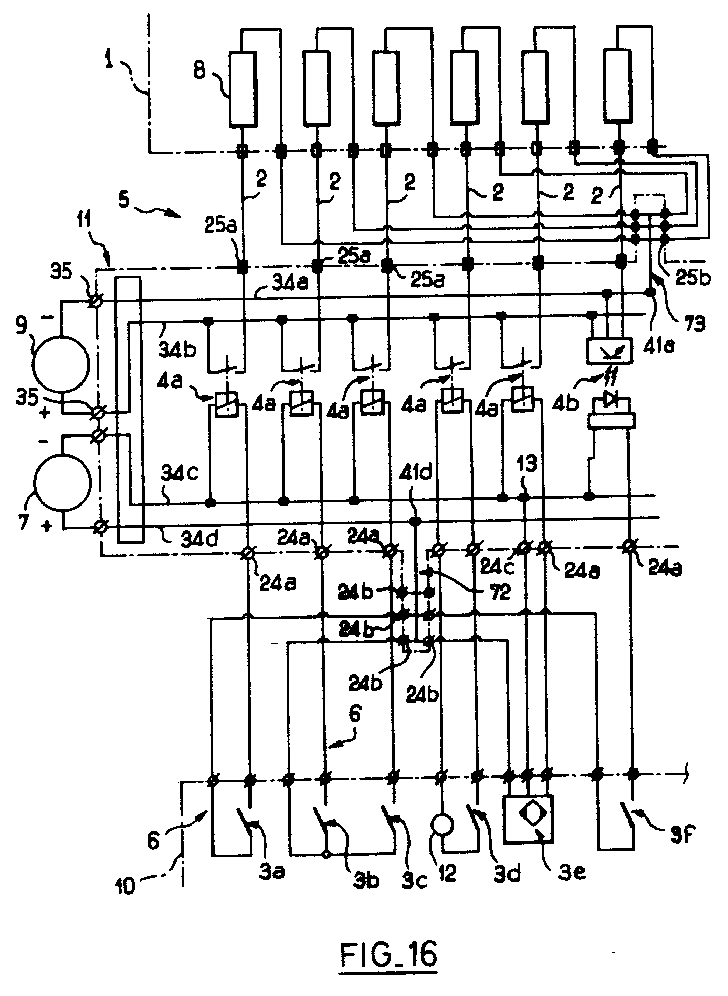

Dans l'exemple représenté à la figure 16, qui est relatif à une interface d'entrée, et qui ne sera décrit qu'en ce qui concerne ses différences par rapport à la figure 1, il a été ajouté au dispositif d'interface 11 un module de commun "installation" 72 et un module de commun "traitement" 73. Les modules d'interface ne comportent plus la borne de commun "installation" 24b, ce qui permet de réduire la largeur de chaque module et sa complexité.

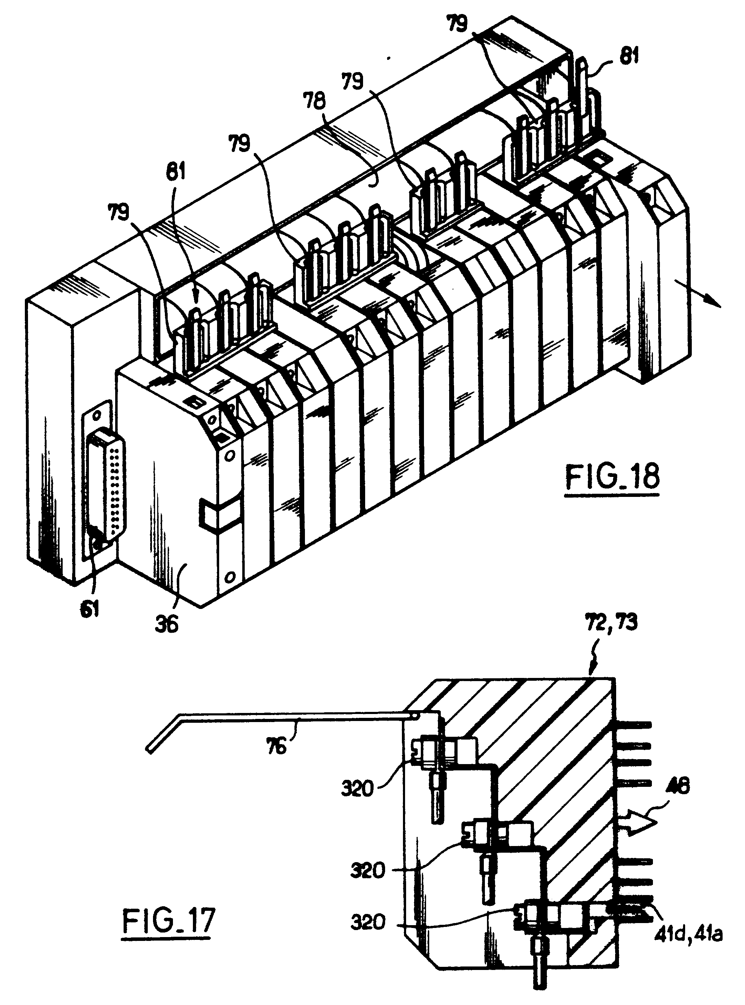

Le module de commun "installation" 72 comprend (voir aussi figure 17) un contact 41d pour son raccordement avec le conducteur de commun 34d, et une série de bornes extérieures de commun 24b auxquelles sont reliées les extrémités correspondantes des détecteurs 3a à 3f.

Ainsi trois résultats importants sont obtenus :
- on a simplifié tous les modules d'interface et on a réduit leur largeur et leur nombre de bornes extérieures.
- au cas où un module d'interface doit être démonté pour être remplacé, il y a moins de bornes extérieures à déconnecter, puisque les bornes 24b ne sont plus sur les modules ; et
- certains dispositifs d'interface, comme ceux représentés à la figure 16, sont devenus symétriques, c'est-à-dire peuvent, à partir de la situation représentée, être transformés en modules d'interface de sortie par simple pivotement à 180° autour d'un axe perpendiculaire au plan de la figure 16, puis être raccordés à une sortie de signal 17 et à un actionneur 18.

Par exemple, un module actif peut être montable de façon que la partie commandée du relais 4a ou 4b soit côté automate 1 pour réaliser un module d'entrée ou côté installation 10 pour réaliser un module de sortie. Pour cela, on fait en sorte que les moyens par lesquels l'embase et les modules se positionnent réciproquement soient symétriques par rapport à un plan longitudinal, de préférence médian, de l'embase. Les becs de verrouillage 48 ont alors une forme de flèche (voir figure 17 qui sera décrite plus en détail plus loin) pour pouvoir coopérer avec le verrou 42 dans les deux orientations du module par rapport à l'embase.

Au contraire, dans le mode de réalisation correspondant à la figure 1, il faut plus de bornes extérieures du côté installation et les modules d'interface ne pourraient être réversibles qu'à condition de prévoir initialement un nombre surabondant de bornes extérieures du côté "traitement".

Dans l'exemple représenté à la figure 16, les moyens de traitement 8 ne sont plus interconnectés entre eux à l'intérieur de l'automate 1 et doivent donc tous être reliés individuellement au commun d'une source extérieure. En pratique, ceci donne plus de possibilités de montage que la réalisation de la figure 1 avec interconnexion à l'intérieur de l'automate 1.

Grâce au module de commun "traitement", il a été inutile de prévoir une borne de commun sur chaque module d'interface. L'extrémité correspondante de chaque moyen de traitement 8 est reliée par un fil à l'une des bornes extérieures 25b du module de commun 73, qui comporte en outre un contact 41a pour relier toutes les bornes 25b avec le conducteur de commun 34a.

En pratique, les modules de commun "installation" 72 et "traitement" 73 peuvent être identiques : il suffit de faire pivoter le module de 180° pour que ces bornes extérieures 24b ou 25b soient reliées au conducteur de commun 34d ou respectivement 34a pour réaliser un module de commun "installation" ou respectivement un module de commun "traitement", le bec 48 ayant la forme de flèche déjà décrite.

Comme le montre la figure 17, les bornes 24b ou 25b peuvent être des serre-fils 320 répartis en gradins sur la face frontale du module de commun 72 ou 73 et recouvertes par un capot pivotant 76.

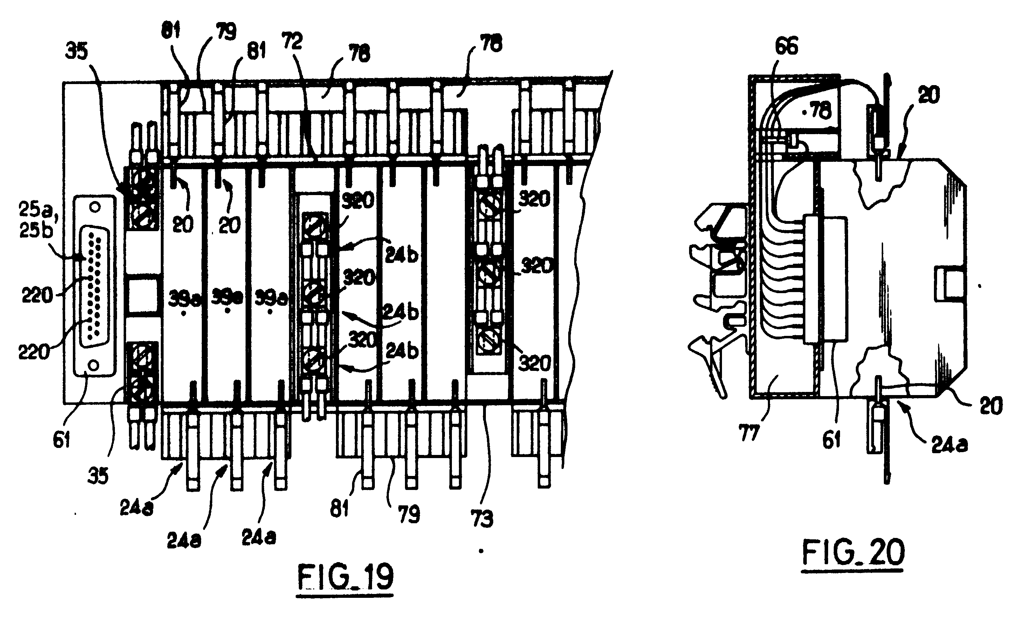

Dans l'exemple pratique représenté aux figures 18 et 19, le connecteur multibroches 61 de liaison avec l'automate est porté à une extrémité de l'embase, au-delà du bloc d'alimentation 36. Depuis l'arrière du connecteur multibroches 61, les conducteurs souples de signal et de commun passent dans une cavité 77 ménagée derrière le connecteur, puis, de la dans une goulotte 78 pour aboutir aux serre-fils latéraux 20 des modules, côté "traitement" ou aux serre-fils 320 du module de commun "traitement" 73. Les serre-fils 20 côté "traitement" et les serre-fils 20 constituant les bornes de signal "installation" 24a sont en position symétrique sur deux faces opposées des modules et forment donc deux rangées rectilignes, l'une au-dessus et l'autre au-dessous des modules.

Bien entendu, l'invention n'est pas limitée aux exemples décrits et représentés.

Il peut exister d'autres types de relais, de détecteurs et d'actionneurs que ceux représentés.

Dans les applications de petite taille, on pourrait monter sur une même embase tous les modules d'interface d'entrée et de sortie nécessaires pour piloter une installation.

Dans tous les cas, l'installateur ou l'utilisateur peut à sa guise ordonner comme il le veut les modules les uns par rapport aux autres, indépendamment de la configuration de l'automate et il peut réaliser les schémas d'entrée et de sortie les plus variés sans être en aucune manière limité par les interconnexions qui préexistent dans l'embase.

Quand l'embase comporte les puits 51, on pourrait prévoir que les conducteurs en provenance de l'automate soient directement équipés pour être introduits dans ces puits. Ceux-ci constituent alors les bornes de signal 25 des figures 1 à 4 et aucun des équipements intermédiaires 52, 61, 67 n'est nécessaire.

## Revendications

1. Dispositif d'interface destiné à être interposé électriquement entre les entrées ou sorties d'une unité de traitement (1) telle qu'un automate programmable et les capteurs ou actionneurs d'une installation (10) reliée à cette unité, ce dispositif (11) comprenant une embase (28) sur laquelle des modules d'interface (39a-39c) peuvent être montés et reliés électriquement avec des moyens de raccordement électrique (34a-34d) contenus dans l'embase, caractérisé en ce que
- l'embase (28) comprend une paroi (29) à travers laquelle sont ménagées des fenêtres (31a-31f) disposées en rangées et en colonnes, en ce que les colonnes de fenêtres sont réparties selon un pas déterminé, et les modules comprennent au moins deux types (39a, 39b, 39c) de largeur différente et égale à un nombre entier de fois ledit pas,
- en ce que les moyens de raccordement comprennent des conducteurs de commun (34a, 34b) côté traitement et (34c, 34d) côté installation disposés parallèlement les uns aux autres chacun en regard des fenêtres (31a-31d) de l'une des rangées, et en ce que chaque module (39a-39c) comprend au moins un contact (41a-41d) enfichable sur un conducteur de commun (34a-34d) à travers une fenêtre (31a-31d) recouverte par ce module,
- en ce que l'embase (28) comprend un module de raccordement d'alimentation (36) pour les entrées ou sorties de l'unité de traitement, dans lequel les conducteurs de commun (34a, 34b) côté traitement sont raccordés à des bornes d'alimentation (35).

2. Dispositif conforme à la revendication 1, caractérisé en ce que le module de raccordement d'alimentation (36) est muni de bornes d'alimentation pour le côté traitement et de bornes d'alimentation pour le côté installation des modules d'interface.

3. Dispositif conforme à la revendication 1, caractérisé en ce que l'embase (28) porte sous l'une des rangées de fenêtres (31e) un verrou (42) commun à toutes les colonnes de fenêtres, en ce que chaque module comporte une conformation de verrouillage (47) disposée pour pénétrer dans l'une des fenêtres (31e) de cette rangée et coopérer avec le verrou (42), lequel empêche sélectivement le démontage des modules, et en ce qu'un dispositif (44) de commande centralisée du verrou est prévu sur l'embase ou sur un module de raccordement d'alimentation.

4. Dispositif conforme à l'une des revendications 1 à 3, caractérisé en ce que chaque module comporte au moins un dispositif (20) de raccordement extérieur pour constituer ou être raccordé à une borne extérieure de signal (24a, 25a) du dispositif d'interface, cette borne extérieure pouvant être reliée à l'unité de traitement ou à l'installation.

5. Dispositif conforme à l'une des revendications 1 à 4, caractérisé en ce que l'embase comprend pour certaines au moins des colonnes de fenêtres une fenêtre de contact de signal (31f), destinée à recevoir un contact de signal (41f) des modules, et reliée intérieurement à des moyens de connexion (51, 54) du contact de signal (41f) avec un moyen de raccordement (120, 220) constituant une borne extérieure de signal (25a) du dispositif d'interface.

6. Dispositif conforme à la revendication 5, caractérisé en ce que les moyens de connexion comportent au moins un bornier (52) comprenant plusieurs moyens de raccordement (120) formant bornes extérieures de signal (25a) du dispositif d'interface et reliés à des fiches individuelles (53) et engageables ensemble dans plusieurs puits (51) prévus sur l'embase.

7. Dispositif conforme à l'une des revendications 1 à 6, caractérisé en ce qu'il comprend des moyens de répartition comprenant un connecteur multi-voies (61) pour le raccordement avec l'unité de traitement et des moyens pour relier chaque voie (220) du connecteur (61) avec l'un des modules (39a-39c), le cas échéant par l'intermédiaire de l'embase (28).

8. Dispositif conforme à l'une des revendications 1 à 7, caractérisé en ce que des modules comprennent au moins une borne extérieure de commun (24b, 25b) reliée à un contact de raccordement (41a, 41d) enfichable sur un conducteur de commun (34a, 34d).

9. Dispositif conforme à l'une des revendications 1 à 7, caractérisé en ce qu'il comprend au moins un module de commun (72, 73) comprenant un contact de commun (41a, 41d) enfichable sur un conducteur de commun (34a - 34f) et plusieurs moyens de raccordement (320) reliés électriquement à ce contact de commun, de manière à permettre de fermer plusieurs circuits (5, 6) à l'extérieur du dispositif d'interface entre des bornes de signal associées à plusieurs modules d'interface et ledit module de commun.

10. Dispositif conforme à la revendication 9, caractérisé en ce que les modules de commun (72, 73) et/ou certains au moins des modules d'interface (39) sont montables dans deux positions inverses l'une de l'autre sur l'embase (28) pour intervertir leur côté traitement et leur côté installation.

## Patentansprüche

1. Schnittstelleneinrichtung, vorgesehen für die elektrische Einschaltung zwischen den Eingängen und Ausgängen einer Verarbeitungseinheit (1) wie zum Beispiel einer programmierbaren Steuerung und den Sensoren oder den Stellgliedern einer mit dieser Einheit verbundenen Anlage (10), wobei diese Einrichtung (11) eine Trägerplatte (28) aufweist, worauf man Schnittstellenmodulen (39a-39c) montieren kann, um sie dann elektrisch mit in der Trägerplatte enthaltenen elektrischen Anschlussmitteln zu verbinden, dadurch gekennzeichnet dass :
. die Trägerplatte (28) mit einer Wand (29) versehen ist, in welcher Fenster (31a-31f) in Reihen und Spalten angeordnet sind, indem die Fensterspalten gemäss einem festgesetzten Schritt verteilt sind, und die Modulen mindestens zwei verschiedene Breiten (39a, 39b, 39c) erweisen, die einem geraden Vielfaches des genannten Schrittes entsprechen,
. die Anschlussmittel auf der Verarbeitungsseite und auf der Installationsseite Gemeinschaftsleiter (34a, 34b ; bzw 34c, 34d) beinhalten, die zueinander, jeder gegenüber der Fenster (31a-31d) einer Reihe stehend, gleichgerichtet sind, und jeder Modul (39a-39c) mindestens einen Kontakt (41a-41d) beinhaltet, der einem von diesem Modul bedeckten Fenster hindurch (31a-31d) auf einen Gemeinschafsleiter (34a-34d) einsteckbar ist,
. die Trägerplatte (28) mit einem Netzanschlussmodul (36) für die Ein- oder Ausgänge der Verarbeitungseinheit versehen ist, worin die Gemeinschaftsleiter (34a-34b) auf der Verarbeitungsseite mit Netzanschlussklemmen (35) verbunden sind.

2. Schnittstelleneinrichtung gemäss dem Anspruch 1, dadurch gekennzeichnet, dass das Netzanschlussmodull (36) mit Netzanschlussklemmen für die Verarbeitungsseite und Netzanschlussklemmen für die Installationsseite der Schnittstellenmodulen versehen ist.

3. Schnittstelleneinrichtung gemäss dem Anspruch 1, dadurch gekennzeichnet, dass die Trägerplatte (28) unter einer der Fensterreihe (31e) mit einem der gesamten Fensterspalten gemeinsamen Riegel versehen ist, indem jeder Modul eine Verriegelvorrichtung (47) beinhaltet, die derweise angerichtet ist, dass sie in eines der Fenster (31e) dieser Reihe eindringt und mit dem Riegel (42) zusammenwirkt, der die Demontage der Modulen selektiv verhindert, indem auf der Trägerplatte oder auf einem Netzanschlussmodul, für den Riegel eine zentralisierte Steuervorrichtung (44) vorgesehen ist.

4. Schnittstelleneinrichtung gemäss einem der Ansprüche 1 bis 3, dadurch gekennzeichnet, das jeder Modul mindestens eine Vorrichtung (20) für Aussenanschluss trägt, um eine äussere Signalklemme (24a, 25a) der Schnittstelleneinrichtung zu bilden oder damit verbunden zu sein, wobei diese Aussenklemme mit der Verarbeitungseinheit oder mit der Anlage angeschlossen werden kann.

5. Schnittstelleneinrichtung gemäss einem der Ansprüche 1 bis 4, dadurch gekennzeichnet, dass die Trägerplatte mindestens für einige der Fensterspalten ein Signalkontaktfenster (31f) beinhaltet, das vorgesehen ist um einen Signalkontakt (41f) der Modulen zu empfangen, und dass in seiner Innenseite mit Anschlussmittel (51, 54) des Signalkontakts (41f) mittels einem Verbindungsmittel (120, 220) verbunden ist, das eine Aussensignalklemme (25a) der Schnittstelleneinrichtung bildet.

6. Schnittstelleneinrichtung gemäss Anspruch 5, dadurch gekennzeichnet, dass die Anschlussmittel mindestens mit einer Anschlusstelle (52), die aus mehreren Anschlussmittel (120) besteht, welche die Aussensignaklemmen (25a) der Schnittstelleneinrichtung bilden, versehen sind, und an gemeinsam in mehreren auf der Trägerplatte vorgesehenen Schächten (51) einsteckbaren Einzelstecker (53) verbunden sind.

7. Schnittstelleneinrichtung gemäss einem der Ansprüche 1 bis 6, dadurch gekennzeichnet, dass sie mit Verteilungsmitteln, die einen Mehrkanalstecker (61) für die Verbindung mit der Verarbeitungseinheit beinhalten, und mit Verbindungsmitteln für den Anschluss von jedem Kanal (220) des Verbinders (61) mit einem der Modulen (39a-39c), gegebenenfalls über die Trägerplatte (28), ausgerüstet ist.

8. Schnittstelleneinrichtung gemäss einem der Ansprüche 1 bis 7, dadurch gekennzeichnet, dass die Modulen mindestens mit einer gemeinsamen Aussenklemme (24b, 25b) versehen sind, die mit einem auf einen Gemeinschaftsleiter (34a, 34d) einsteckbaren Anschlusskontakt verbunden ist.

9. Schnittstelleneinrichtung gemäss einem der Ansprüche 1 bis 7, dadurch gekennzeichnet, dass sie mindestens mit einem Gemeinschaftsmodul (72, 73) versehen ist, das einen Gemeinschaftskontakt (41a, 41d) der auf einen Gemeinschaftsleiter (34a-34f) einsteckbar ist, und mehrere Anschlussmittel (320), die mit diesem Gemeinschaftskontakt elektrisch verbunden sind, aufweist, um mehrere Leitungen (5, 6), ausserhalb der Schnittstelleneinrichtung, zwischen den mit mehreren Schnittstellenmodulen und dem gennannten Gemeinschaftsmodul verbundenen Signaklemmen zu schliessen.

10. Schnittstelleneinrichtung gemäss Anspruch 9, dadurch gekennzeichnet, dass die Gemeinschaftsmodulen (72, 73) und/oder mindestens ein Teil der Schnittstellenmodulen (39) in zwei zueinander entgegenstehenden Stellungen auf der Trägerplatte (28) montierbar sind, im ihre Verarbeitungs-und Installationsseite austauschen zu können.

## Claims

1. An interface device for placing electrically between the inputs or outputs of a processing unit (1) such as a programmable controller and the sensors or actuators of an installation (10) connected to said unit, said device (11) comprising a base (28) on which interface modules (39a-39c) can be mounted and electrically connected to electrical connection means (34a-34d) contained in the base, the device being characterized in that :
- the base (28) comprises a wall (29) through which windows (31a-31f) are formed and organized in rows and in columns, in that the columns of windows are distributed at a set pitch and the modules comprise at least two types of module (39a, 39b, 39c) of different widths equal to different integer multiples of said pitch,
- in that the connection means comprise common conductors (34a, 34b) on the processing side and (34c, 34d) on the installation side disposed in parallel to one another, each facing the windows (31a-31d) of one of the rows, and in that reach module (39a-39c) includes at least one contact (41a-41d) pluggable onto a common conductor (34a-34d) through a window (31a-31d) covered by said module,
- in that the base (28) includes for the inputs or outputs of the processing unit a power supply connection module (36), in which the common conductors (34a, 34b) on the processing side are connected to power supply terminals (35).

2. A device according to claim 1, characterized in that the power supply connection module (36) is provided with power supply terminals for the processing side and with power supply terminals for the installation side of the interface modules.

3. A device according to claim 1, characterized in that the base (28) carries behind one of its row of windows (31e) a catch (42) which is common to all of the columns of windows, in that each module includes a latching shape (47) disposed to penetrate into one of the windows (41e) of said row and to co-operate with the catch (42), thereby selectively preventing modules from being removed, and that a centralized control device (44) for the catch is provided on the base on the power supply connection module.

4. A device according to one of claims 1 to 3, characterized in that each module includes at least one external connection device (20) for constituting or for being connected to an external signal terminal (24a, 25a) of the interface device, said external terminal being connectable to the processing unit or to installation.

5. A device according to one of claims 1 to 4, characterized in that the base includes, for at least some of the columns of windows, a signal contact window (31f) designed to receive a signal contact (41f) of the modules, and connected internally to connection means (51, 54) for connecting the signal contact (41f) with connection means (120, 220) constituting an external signal terminal (25a) of the interface device.

6. A device according to claim 5, characterized in that the connection means comprise at least one terminal strip (52) including a plurality of connection means (120) forming external signal terminals (25a) of the interface device and connected to individual plugs (53) and connectable together in a plurality of wells (51) provided on the base.

7. A device according to one of claims 1 to 6, characterized in that it includes distributor means comprising a multi-path connector (61) for connecting to the processing unit and means for connecting each path 220 of the connector (61) to one of the modules (39a-39c), when necessary, via the base (28).

8. A device according to one of claims 1 to 7, characterized in that the modules include at least one common external terminal (24b, 25b) connected to a connection contact (41a, 41d) pluggable onto a common conductor (34a, 34d).

9. A device according to one of claims 1 to 7, characterized in that it includes at least one common module (72, 73) including a common contact (41a, 41d) pluggable onto a common conductor (34a-34f) together with a plurality of connection means (320) electrically connected to said common contact, thereby enabling a plurality of circuits (5, 6) to be closed outside the interface device between the signal contacts associated with a plurality of interface modules and with said common modules.

10. A device according to claim 9, characterized in that the common modules (72, 73) and/or at least some of the interface modules (39) are connectable in two mutually opposite positions on the base (28) so as to interchange their processing and installation sides.
